# EUROPÄISCHE PATENTSCHRIFT

(11) **EP 3 186 819 B1**
(45) Veröffentlichungstag und Bekanntmachung des Hinweises auf die Patenterteilung: **15.08.2018**
(21) Anmeldenummer: 15763831.3
(22) Anmeldetag: 26.08.2015
(51) Int. Cl.: H01J 37/18, H01J 37/30, B23K 15/06

(54) **TEILCHENSTRAHLBEARBEITUNGSVORRICHTUNG**
PARTICLE BEAM PROCESSING DEVICE
DISPOSITIF D'USINAGE PAR JETS DE PARTICULES

(30) Priorität: 28.08.2014 DE 102014012816
(43) Veröffentlichungstag der Anmeldung: 05.07.2017
(73) Patentinhaber: Global Beam Technologies AG, 82216 Maisach (DE)
(72) Erfinder: VOKURKA, Franz, 1140 Wien (AT)
(74) Vertreter: Kramer Barske Schmidtchen Patentanwälte PartG mbB
(86) Internationale Anmeldenummer: PCT/EP2015/001742
(87) Internationale Veröffentlichungsnummer: WO 2016/030015

(56) Entgegenhaltungen:
- EP-A1- 2 353 955
- DE-A1-102008 059 741
- JP-A- H02 155 580
- US-A- 3 592 995

## Beschreibung

Die vorliegende Erfindung bezieht sich auf eine Teilchenstrahlbearbeitungsvorrichtung nach dem Oberbegriff eines der Ansprüche 1 und 9.

Eine solche Teilchenstrahlbearbeitungsvorrichtung ist beispielsweise aus der DE 10 2008 059 741 A1 bekannt. Ein Beispiel für eine Teilchenstrahlbearbeitungsvorrichtung ist eine Elektronenstrahlbearbeitungsvorrichtung, bei der eine Elektronenstrahlkanone zur Bearbeitung von Werkstücken in einer Vakuumkammer eingesetzt wird. Elektronenstrahlerzeuger sind allgemein bekannt, beispielsweise aus der US 5,089,686.

In der eingangs erwähnten DE 10 2008 059 741 A1 ist eine Vakuumkammer mit einer Rotoreinrichtung gezeigt, die Rotoröffnungen aufweist, um die jeweils eine Dichtung angebracht ist. Die Dichtungen befinden sich bei einer Drehung der Rotoreinrichtung stets in Eingriff mit einem derselben gegenüberliegenden Gehäusedeckel. Dies führt zu einem Verschleiß der Dichtungen aufgrund des permanenten Eingriffs mit dem Gehäusedeckel.

Die US 4,162,391 zeigt eine Teilchenstrahlbearbeitungsvorrichtung mit einem Drehtisch, in dem mehrere Öffnungen bzw. Kammern ausgebildet sind. Die jeweiligen Kammern werden durch Drehung des Drehtisches in Bezug auf eine Abdichtplatte jeweils an eine evakuierte Bearbeitungsposition gebracht. Dabei sind an der Abdichtplatte Dichtungen angeordnet, die diejenigen Kammern, die innerhalb des Bereichs derselben liegen, gegenüber dem Äußeren abdichten. Somit sind auch die Dichtungen der US 4,162,391 stets in Eingriff mit dem Drehtisch.

Die DD 208 200, die DE 961 369, die DE 20 2006 008 303 U1, die GB 923,533, die DE 103 55 683 A1 und die DE 197 42 923 A1 zeigen allesamt Vorrichtungen zum Durchführen einer Bearbeitung unter Vakuum, bei denen bei einem Werkstückwechsel bzw. einer Bearbeitung eines Werkstücks eine Dichtung gegenüber einer entsprechenden Abdeckung dadurch hergestellt wird, dass ein Rotor in einer axialen Richtung desselben bewegt und gegen die Abdeckung gedrückt wird. Somit sind aufwendige Bewegungsvorrichtungen zum Bewegen des Rotors sowohl in axialer Richtung als auch um seine Drehachse erforderlich, was insbesondere eine Fehleranfälligkeit und einen Wartungsaufwand erhöht.

Die US 3,592,995 offenbart eine Elektronenstrahlschweißvorrichtung mit einem zylindrischen Außengehäuse. Mehrere in Umfangsrichtung gleichmäßig beabstandete Kammern sind mit einem zentralen drehbaren Träger verbunden und stehen für einen dichtenden Eingriff mit dem äußeren Gehäuse nach außen vor. Arbeitsstationen befinden sich um die Anordnung herum und beinhalten eine Ladestation, ein Paar von Vakuumpumpstationen, eine Schweißstation und eine Entladestation.

Aufgabe der Erfindung ist es, eine bekannte Teilchenstrahlbearbeitungsvorrichtung im Hinblick auf ihre praktische Einsetzbarkeit zu verbessern.

Diese Aufgabe wird gelöst durch eine Teilchenstrahlbearbeitungsvorrichtung nach Anspruch 1. Weiterbildungen der Erfindungen sind in den Unteransprüchen angegeben.

Das Vorsehen einer Abdichteinrichtung an einer Abdeckung für einen Rotor mit mehreren Kammern, die zum Eingriff mit einer eine Kammeröffnung des Rotors umgebenden Dichtung und als eine in Richtung des Rotors vorstehende Verdickung der Abdeckung ausgebildet ist, ermöglicht ein Wechseln eines Werkstücks in der einen Kammer, während gleichzeitig eine Bearbeitung eines anderen Werkstücks in einer anderen Kammer des Rotors durchgeführt werden kann. Dabei kommt die Abdichteinrichtung bei einer Drehung des Rotors automatisch in Eingriff mit der Dichtung, ohne dass der Rotor in axialer Richtung bewegt werden muss. Ferner ist die Dichtung bei der Drehung des Rotors nicht in ständigem Eingriff mit der Abdeckung.

Weitere Merkmale und Zweckmäßigkeiten ergeben sich aus der Beschreibung von Ausführungsbeispielen anhand der Figuren. Von den Figuren zeigen:
Fig. 1 eine schematische Draufsicht auf eine Teilchenstrahlbearbeitungsvorrichtung gemäß einer beispielhaften Ausführungsform;
Fig. 2 eine Schnittansicht entlang der Linie A-B in Fig. 1;
Fig. 3 einen vergrößerten Ausschnitt der Fig. 2;
Fig. 4 Schnittansichten von Dichtungen einer Teilchenstrahlbearbeitungsvorrichtung gemäß einer beispielhaften Ausführungsform;
Fig. 5 eine Schnittansicht einer Teilchenstrahlbearbeitungsvorrichtung gemäß einer beispielhaften Ausführungsform;
Fig. 6 eine Schnittansicht einer Teilchenstrahlbearbeitungsvorrichtung gemäß einer beispielhaften Ausführungsform;
Fig. 7 eine Schnittansicht einer Teilchenstrahlbearbeitungsvorrichtung gemäß einer beispielhaften Ausführungsform;
Fig. 8 eine Schnittansicht einer Teilchenstrahlbearbeitungsvorrichtung gemäß einer beispielhaften Ausführungsform;
Fig. 9 eine schematische Draufsicht, verschiedene Ausschnitte sowie eine weitere Schnittansicht der Teilchenstrahlbearbeitungsvorrichtung in Fig. 8;
Fig. 10 eine schematische Draufsicht einer Teilchenstrahlbearbeitungsvorrichtung gemäß einer beispielhaften Ausführungsform;
Fig. 11 eine schematische Draufsicht und eine Schnittansicht einer Teilchenstrahlbearbeitungsvorrichtung gemäß einer beispielhaften Ausführungsform; und
Fig. 12 eine schematische Draufsicht und eine Schnittansicht einer Teilchenstrahlbearbeitungsvorrichtung gemäß einer beispielhaften Ausführungsform.

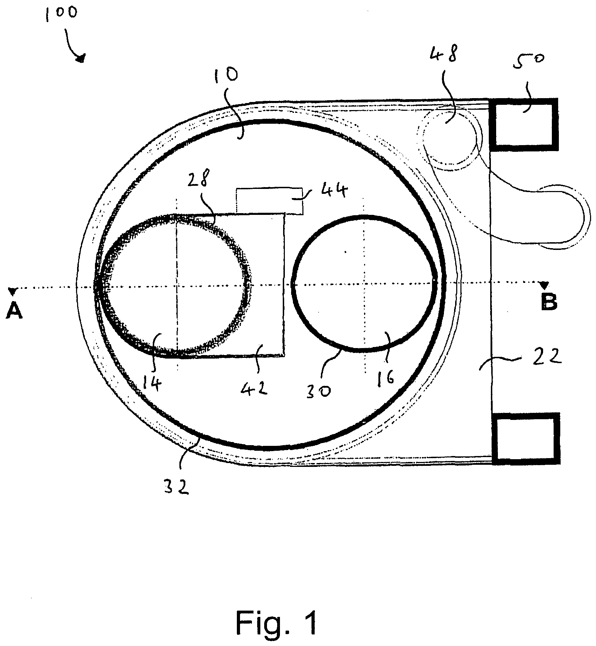

Nachfolgend werden Ausführungsformen einer Elektronenstrahlbearbeitungsvorrichtung als ein Beispiel für eine Teilchenstrahlbearbeitungsvorrichtung unter Bezugnahme auf die Fig. 1 bis 12 beschrieben.

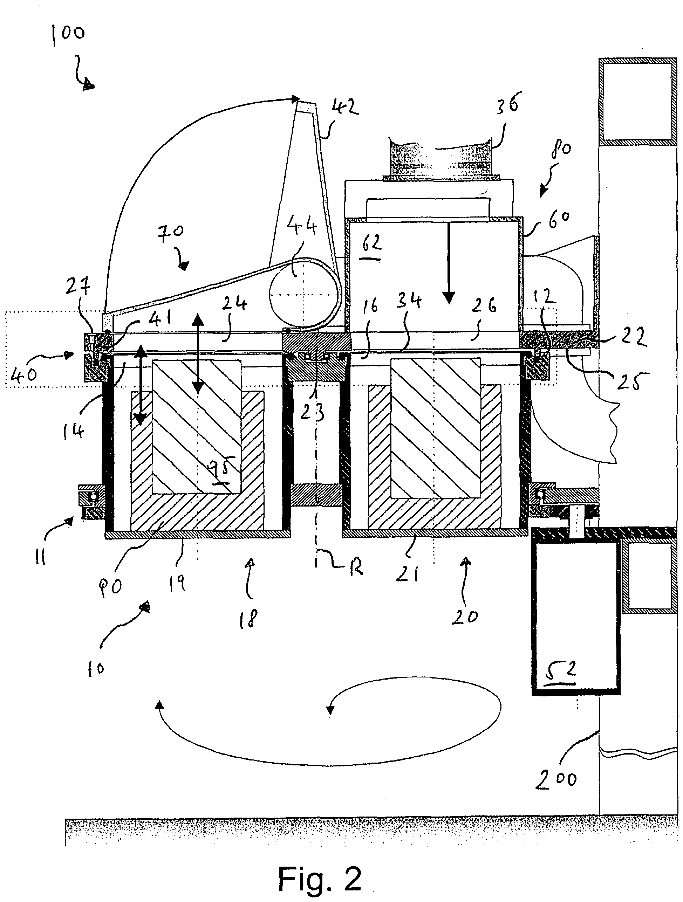

Fig. 1 zeigt eine Elektronenstrahlbearbeitungsvorrichtung 100 in einer schematischen Draufsicht, und Fig. 2 zeigt eine Schnittansicht der Elektronenstrahlbearbeitungsvorrichtung 100 entlang der Linie A-B in Fig. 1. Die Elektronenstrahlbearbeitungsvorrichtung 100 weist einen Rotor 10 und eine Abdeckung 22 auf. Der Rotor 10 sowie die Abdeckung 22 sind beispielsweise an einem Rahmen 200 montiert (siehe Fig. 2). Der Rotor 10 ist über ein Lager 11 drehbar um eine Drehachse R an dem Rahmen 200 gelagert. Die Abdeckung 22 ist über eine Schwenkvorrichtung 50 (siehe Fig. 1) schwenkbar an dem Rahmen 200 befestigt. Bei anderen Ausführungsformen kann die Abdeckung 22 auch auf andere Weise montiert sein. Beispielsweise kann die Abdeckung 22 über einen Linearantrieb bezüglich des Rotors 10 verschoben werden, so dass sie den Rotor 10 wahlweise abdeckt oder freigibt.

Der Rotor 10 weist eine der Abdeckung 22 zugewandte Oberseite 12, eine erste Kammer 18 und eine zweite Kammer 20 auf. Die erste Kammer 18 weist eine in der Oberseite 12 des Rotors 10 ausgebildete erste Kammeröffnung 14 auf, und die zweite Kammer 20 weist eine in der Oberseite 12 des Rotors 10 ausgebildete zweite Kammeröffnung 16 auf. Bei der in Fig. 1 und 2 gezeigten beispielhaften Ausführungsform sind die Kammern 18, 20 als im Wesentlichen zylindrische Kammern mit einem offenen Ende und einem geschlossenen Ende ausgebildet. Die Kammern 18, 20 sind mit der Oberseite 12 des Rotors, die in Form einer beispielsweise kreisförmigen Platte ausgebildet sein kann, verbunden, zum Beispiel angeflanscht oder anderweitig an derselben befestigt. Bei anderen Ausführungsformen können die Kammern 18, 20 integral mit der Oberseite 12 ausgebildet sein. Ferner kann die Oberseite 12 des Rotors 10 in der Draufsicht eine beliebige Form aufweisen. Auf einem Kammerboden 19 der ersten Kammer 18 bzw. einem Kammerboden 21 der zweiten Kammer 20 kann eine Werkstückaufnahme bzw. Werkstückhaltevorrichtung 90 angeordnet werden, in der ein zu bearbeitendes Werkstück 95 angeordnet werden kann.

Ein Rotorantrieb 52 ist an dem Rahmen 200 befestigt, so dass er mit einem an dem Rotor 10 ausgebildeten Zahnkranz oder dergleichen in Eingriff ist und den Rotor 10 um die Drehachse R drehen kann.

Die Abdeckung 22 liegt der Oberseite 12 des Rotors 10 gegenüber, wenn sie sich in dem in Fig. 1 und 2 gezeigten Abdeckzustand befindet, das heißt, den Rotor 10 abdeckt bzw. verschließt. Über die Schwenkvorrichtung 50 kann die Abdeckung 22 sowie sämtliche darauf angebrachten Vorrichtungen, auf die im Folgenden eingegangen wird, von dem Rotor 10 weggeschwenkt werden, so dass beispielsweise eine Wartung oder dergleichen durchgeführt werden kann.

Die Abdeckung 22 kann in Form einer flachen Platte ausgebildet sein und weist eine Unterseite 25 auf, die im geschlossenen Zustand der Oberseite 12 des Rotors 10 gegenüberliegt, wobei ein Spalt bzw. Raum 34 zwischen Rotor 10 und Abdeckung 12 ausgebildet ist.

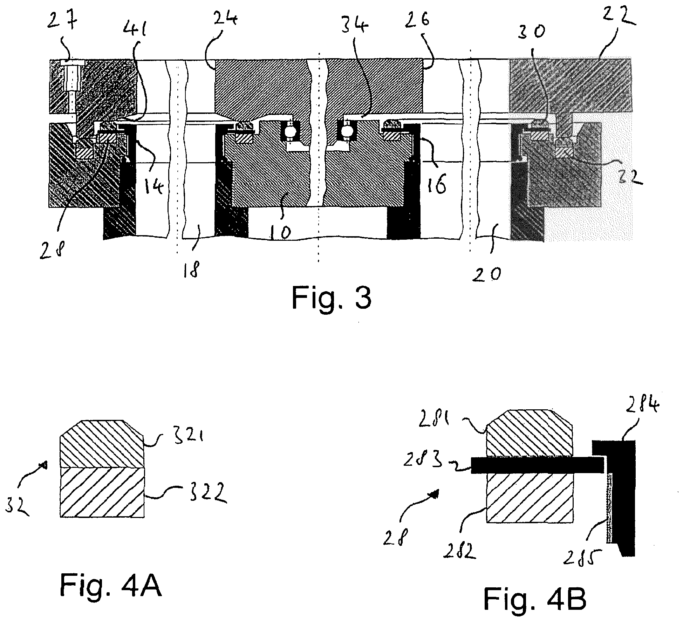

Fig. 3 zeigt einen vergrößerten Ausschnitt der Fig. 2, in dem der Raum 34 deutlich zu sehen ist. Über eine die Kammern 18, 20 umgebende endlose Dichtung 32 ist die Abdeckung 22 in geschlossenem Zustand dichtend mit dem Rotor 10 bzw. der Oberseite 12 desselben verbunden. Zur Abstützung der Abdeckung 22 gegenüber dem Rotor 10 kann eine Abstützvorrichtung 23 (siehe Fig. 2) auf der Unterseite 25 der Abdeckung 22 vorgesehen sein, die diese bei geschlossener Abdeckung 22 an dem Rotor 10 abstützt und auf diesem gelagert ist. Bei dem in Fig. 2 gezeigtem Beispiel ist die Abstützvorrichtung 23 in dem zentralen Bereich der Abdeckung 22 ausgebildet. Wie in Fig. 2 und 3 gezeigt, kann auf der Außenseite der Dichtung 32 ein Kanal 27 in der Abdeckung 22 zum Zuführen eines Gleitmittels oder dergleichen zu der Dichtung 32 ausgebildet sein.

Die Abdeckung 22 weist eine erste Arbeitsöffnung 24 und eine zweite Arbeitsöffnung 26 auf, die in derselben ausgebildet sind. Die erste Arbeitsöffnung 24 und die zweite Arbeitsöffnung 26, die gegenüber dem Rotor 10 stationär sind, sind jeweils durch eine erste Arbeitsstation und eine zweite Arbeitsstation vakuumdicht verschlossen bzw. verschließbar, was im Folgenden genauer erläutert wird. Insbesondere ist bei der in Fig. 1 und 2 gezeigten beispielhaften Ausführungsform die erste Arbeitsstation, die über der ersten Arbeitsöffnung 24 vorgesehen ist, eine Be-/Entladestation 70, während die über der zweiten Arbeitsöffnung 26 angeordnete Arbeitsstation eine Bearbeitungsstation 80 zum Bearbeiten eines Werksstücks mittels eines Elektronenstrahls ist.

Die Be-/Entladestation 70 weist einen auf der Abdeckung 22 schwenkbar angebrachten Deckel 42 auf, der zum selektiven Verschließen und Öffnen der ersten Arbeitsöffnung 24 ausgebildet ist. In dem geschlossenen Zustand dichtet der Deckel 42 die erste Arbeitsöffnung 24 ab. Im in Fig. 2 schematisch gezeigten geöffneten Zustand ermöglicht der Deckel 42 einen Zugang zu der darunter liegenden Kammer, beispielsweise der Kammer 18, wie in Fig. 2 durch einen Pfeil gezeigt ist. Auf diese Weise kann bei geöffnetem Deckel 42 ein Werkstück aus der Kammer 18 entnommen und/oder in diese eingesetzt werden.

Wie im Fig. 2 gezeigt, ist die zweite Arbeitsöffnung 26 vakuumdicht durch die Bearbeitungsstation 80 verschlossen. Insbesondere ist die Arbeitsöffnung 26 der Abdeckung 22 von einem aufgesetzten Bearbeitungsgehäuse 60, das einen Bearbeitungsraum 62 festlegt, vakuumdicht verschlossen. Auf der Oberseite des Bearbeitungsgehäuses 60 ist ein Teilchenstrahlgenerator 36 vakuumdicht aufgesetzt. Der Teilchenstrahlgenerator 36 kann über geeignete Verfahrvorrichtungen, beispielsweise eine oder mehrere Exzenterscheiben, über der Arbeitsöffnung 26 in horizontaler Richtung bewegt werden, so dass in einem Bereich der Arbeitsöffnung 26 eine Bearbeitung eines in der darunterliegenden Kammer 20 vorgesehen Werkstücks erfolgen kann. Alternativ oder zusätzlich dazu kann ein Drehboden in der Kammer 20 vorgesehen sein, der eine Drehung des zu bearbeitenden Werkstücks um eine vertikale Achse ermöglicht, was im Folgenden genauer beschrieben wird. Der Bearbeitungsraum 62 ist mit einer Vakuumpumpe, beispielsweise einer Turbomolekularpumpe, verbunden, über die der Bearbeitungsraum 62, der mit diesem in Verbindung stehende Raum 34 (siehe Fig. 2 und 3) sowie die Kammer 20 evakuiert werden kann. Dementsprechend ist bei geschlossener Abdeckung 22 und geschlossenem Deckel 42 der zwischen der Abdeckung 22 und dem Rotor 10 ausgebildete Raum 34 mittels der Dichtung 32 vakuumdicht gegenüber der Umgebung abgedichtet. Auf diese Weise kann durch die an einer geeigneten Stelle vorgesehene Vakuumpumpe (siehe den schematisch gezeigten Anschluss in Fig. 2) der Raum 34 evakuiert werden. Wie im Folgenden genauer beschrieben wird, steht bei einer Drehung des Rotors 10 zu jedem Zeitpunkt mindestens eine der Kammern 18, 20 mit dem durch die Dichtung 32 abgedichteten Raum 34 in Verbindung. Somit liegt bei einer Evakuierung des Raums 34 auch in der mindestens einen mit diesem Raum verbundenen Kammer ein Vakuum vor. Durch ein im Folgenden beschriebenes spezielles Dichtungssystem wird sichergestellt, dass bei einem Werkstückwechsel über die erste Arbeitsöffnung 24 lediglich die mit dieser Arbeitsöffnung in Übereinstimmung gebrachte Kammer 18, 20 mit der Umgebung in Kontakt kommt, so dass während des Werkstückwechsels der Raum 34 und die andere der Kammern 18, 20 weiterhin evakuiert bleiben.

Genauer gesagt sind auf der Oberseite 12 des Rotors 10 eine erste Dichtung 28 und eine zweite Dichtung 30 vorgesehen, die jeweils die erste Kammeröffnung 14 und die zweite Kammeröffnung 16 umgeben. Die Abdeckung 22 ist dabei derart ausgebildet, dass lediglich an einer Drehposition des Rotors 10, an der eine der Kammern 18, 20 mit der ersten Arbeitsöffnung 24 ausgerichtet bzw. in Übereinstimmung ist, über die zugehörige Dichtung 28 oder 30 eine vakuumdichte Verbindung zwischen der entsprechenden Kammer 18, 20 und der ersten Arbeitsöffnung 24 bzw. der Abdeckung 22 hergestellt wird. An den anderen Drehpositionen des Rotors 10 sind beide Kammern 18, 20 mit dem Raum 34 verbunden. Dazu ist an der Abdeckung 22 eine Abdichteinrichtung 40 vorgesehen, die die erste Arbeitsöffnung 24 umgibt. Erfindungsgemäß ist in Fig. die Abdichteinrichtung 40 als ein auf der Unterseite 25 der Abdeckung 22 ausgebildeter ringförmiger Wulst 41 ausgebildet (siehe Fig. 3), der in Richtung des Rotors 10 vorsteht. Der Durchmesser des Wulsts 41 ist an den Durchmesser der Dichtungen 28, 30 angepasst. Somit kommt die entsprechende der Dichtungen 28, 30 lediglich dann über ihren gesamten Umfang in dichtenden Kontakt mit der Abdeckung 22, wenn sich der Rotor 10 an einer Drehposition befindet, an der eine der Kammern 18, 20 mit der ersten Arbeitsöffnung 24 ausgerichtet ist bzw. die entsprechende Dichtung 28, 30 vollständig mit dem Wulst 41 überlappt. An den anderen Drehpositionen des Rotors 10 sind die Dichtungen 28, 30 zumindest teilweise nicht in dichtendem Kontakt mit der Abdeckung 22, so dass die von diesen Dichtungen umgebenen Kammeröffnungen mit dem Raum 34 in Verbindung stehen.

Die Fig. 4A und 4B zeigen jeweils einen Schnitt durch die beispielhafte Dichtung 32 und die beispielhafte Dichtung 28. Es versteht sich, dass die Dichtung 30 dieselbe Konfiguration wie die Dichtung 28 aufweisen kann.

Wie in Fig. 4A gezeigt, ist bei der vorliegenden Ausführungsform die Dichtung 32 zweiteilig aufgebaut. Beispielsweise kann die Dichtung 32 aus einem Basisteil 322, das aus einem relativ weichen Dichtungsmaterial besteht, und einem Oberteil 321, das aus einem relativ harten, abriebfesten Dichtungsmaterial besteht (z. B. aus PU 90 Sh), ausgebildet sein, die auf geeignete Weise miteinander verbunden sein können, z.B. verklebt oder dergleichen. Auf diese Weise besitzt die Dichtung 32 eine hohe Abriebfestigkeit.

Wie in Fig. 4B gezeigt, ist auch die Dichtung 28 mehrteilig aufgebaut. Insbesondere besteht die Dichtung 28 aus einem relativ weichen Basisteil 282 und einem relativ harten Oberteil 281. Das Basisteil 282 und das Oberteil 281 sind über eine ringförmige Metalleinlage 283 miteinander verbunden. Insbesondere ist das Basisteil unter Verwendung einer Manschette 284 mit einen Sicherungsprofil 285 mittels der Metalleinlage 283 an dem Rotor 10 befestigt. Auf der Oberseite der Metalleinlage 283 ist das relativ harte Oberteil 281 angebracht, beispielsweise mittels einer Klebeschicht. Auf diese Weise kann das Oberteil 281, das abgenutzt werden kann, zusammen mit dem Metallring 283 auf einfache Weise von dem Rotor 10 abgenommen und ausgetauscht werden. Somit weist die Dichtung 28 eine hohe Abriebfestigkeit auf und kann auf einfache Weise ersetzt werden.

Wie in den Fig. 4A und 4B gezeigt, können die Dichtungen im Querschnitt auf beiden Seiten eine Fase, d.h. eine abgeschrägte Seitenfläche aufweisen, die sich unter einem Winkel zu der Oberseite erstreckt. Der Winkel kann beispielsweise zwischen etwa 30° und etwa 60° betragen, z.B. annähernd 50°.

Selbstverständlich können bei anderen Ausführungsformen auch anders aufgebaute Dichtungen 28, 30 und 32 verwendet werden, z.B. O-Ringe und dergleichen.

Die prinzipielle Funktionsweise der in Fig. 1 und 2 gezeigten Teilchenstrahlbearbeitungsvorrichtungen 100 wird im Folgenden erläutert.

Bei der hier beschriebenen beispielhaften Ausführungsform ist die Teilchenstrahlbearbeitungsvorrichtung 100 als eine Zweikammerteilchenstrahlbearbeitungsvorrichtung ausgebildet. Das heißt, der Rotor 10 enthält eine erste Kammer 18 und eine zweite Kammer 20, die in radialer Richtung einander gegenüberliegend und mit gleichem Abstand zur Drehachse R angeordnet sind. Entsprechend sind die erste Arbeitsöffnung 24 und die zweite Arbeitsöffnung 26 ebenfalls in radialer Richtung einander gegenüberliegend in der Abdeckung 22 vorgesehen, und zwar derart, dass die erste Kammeröffnung 14 und die zweite Kammeröffnung 16 gleichzeitig mit der ersten Arbeitsöffnung 24 und der zweiten Arbeitsöffnung 26 in Übereinstimmung bringbar sind. Dies ist schematisch in Fig. 1 gezeigt. Wie in Fig. 1 gezeigt, befindet sich die erste Kammeröffnung 14 in Übereinstimmung mit der von dem Deckel 42 verschlossenen ersten Arbeitsöffnung 24 (siehe auch Fig. 2), während sich die zweite Kammeröffnung 16 in Übereinstimmung mit der zweiten Arbeitsöffnung 26 befindet.

Wenn nun der Zustand vorliegt, in dem der Raum 34 evakuiert worden ist, ist wie vorher beschrieben auch die unterhalb der Bearbeitungsstation 80 angeordnete Kammer (in Fig. 2 die Kammer 20) evakuiert, da sie mit dem Raum 34 in Verbindung steht. Mit anderen Worten, an dieser Position (Bearbeitungsposition) befindet sich die zugehörige Dichtung 30 nicht in Eingriff mit der Abdeckung 22. Somit kann eine im Folgenden genauer beschriebene Bearbeitung eines Werkstücks in der Kammer 20 unter Vakuum durchgeführt werden. Während diese Bearbeitung durchgeführt wird, ist die andere der beiden Kammern (in Fig. 2 die Kammer 18) mit der ersten Arbeitsöffnung 24 ausgerichtet. Somit befindet sich zugehörige Dichtung 28 in Eingriff mit dem Wulst 41 der Abdeckung 22. Auf diese Weise ist das Innere der Kammer 18 von dem Raum 34, in dem das Vakuum vorliegt, vakuumdicht getrennt. Dies ermöglicht, dass der Deckel 42 geöffnet werden kann, ohne das in dem Raum 34 bzw. der anderen Kammer 20 vorliegende Vakuum zu beeinflussen. Zum Ermöglichen des Öffnens des Deckels 42 bzw. Fluten der Kammer 18 kann ein (nicht gezeigtes) Ventil vorgesehen sein. Über eine in Fig. 2 nicht gezeigte Schwenkvorrichtung kann dann der Deckel 42 geöffnet werden, so dass ein bearbeitetes Werkstück aus der Kammer 18 entnommen werden kann und ein zur Bearbeitung vorgesehenes Werkstück in diese eingebracht werden kann. Währenddessen kann die Bearbeitung des Werkstücks in der anderen Kammer 20 fortgesetzt werden.

Nach einer Beladung der Kammer 18 wird der Deckel 42 erneut geschlossen. Dies kann beispielsweise mittels einer pneumatisch betätigten Vorrichtung erfolgen. Nachdem der Deckel 42 die erste Arbeitsöffnung 24 wieder dicht verschließt, kann die Kammer 18 erneut evakuiert werden. Dazu ist in dem Deckel 42 ein Anschluss 44 vorgesehen, der beispielsweise über einen (in Fig. 1 nicht gezeigten) Schlauch mit einer beispielsweise in der Abdeckung 22 ausgebildeten Öffnung 48 verbunden ist, die wiederum mit einer nicht gezeigten Evakuierungsvorrichtung wie einer weiteren Vakuumpumpe in Verbindung stehen kann.

Nach einer Evakuierung der ersten Kammer 18 über den Deckel 42 kann im Inneren der Kammer 18 im Wesentlichen dasselbe Vakuum wie in dem Raum 34 und der Kammer 20 vorliegen. Ist nun die Bearbeitung des Werkstücks in der Kammer 20 beendet, wird der Rotor 10 über die Antriebsvorrichtung 52 um 180° gedreht. Somit ist dann die Kammer 18 mit der zweiten Arbeitsöffnung 26 ausgerichtet bzw. befindet sich unterhalb der Bearbeitungsstation 80, so dass eine Bearbeitung des neu eingebrachten Werkstücks erfolgen kann. Zugleich ist an dieser Position die Dichtung 30, die die zweite Kammer 16 umgibt, durch die Drehung des Rotors 10 aus einem Zustand, in dem sie nicht in Eingriff ist, in einen Zustand, in dem sie in Eingriff mit dem Wulst 41 ist, gebracht worden, so dass nun die Kammer 20 von dem Raum 34 vakuumdicht getrennt ist. Dies ermöglicht das Öffnen des Deckels 42 auf die vorher beschriebene Weise, um das bearbeitete Werkstück zu entnehmen. Der beschriebene Zyklus mit gleichzeitigem Be-/Entladen und Bearbeiten von Werkstücken in den zwei Kammern 18, 20 wird wiederholt durchgeführt. Auf diese Weise ist es nicht notwendig, eine separate Arbeitsstation zur Evakuierung der jeweiligen Kammern nach einem Werkstückwechsel vorzusehen. Stattdessen sind der Rotor 10 und die Abdeckung 22 durch das Dichtungssystem mit den Dichtungen 28, 30, 32 so verbunden, dass die Bearbeitungsstation 80 bzw. die unterhalb derselben angeordnete Kammer stets evakuiert bleiben. Somit steht die gesamte für einen Werkstückwechsel benötigte Zeit zur Durchführung der Bearbeitung zur Verfügung.

Dieses oben beschriebene Arbeitsprinzip kann durch viele Ausführungsvarianten und eine modulare Bauweise eine Anpassung an unterschiedliche Produktionsanforderungen ermöglichen. Dazu erlaubt es einen robusten und präzisen Maschinenbau, der eine extrem hohe Verfügbarkeit der Teilchenstrahlbearbeitungsvorrichtung gewährleistet. Neue Werkstoffe mit hohen Abriebeigenschaften sowie spezielle Geometrien sichern eine hohe Lebensdauer der einzelnen Dichtungen. Beispielsweise können die Dichtungen 28, 30, 32 zumindest teilweise aus PU 90 Sh oder vergleichbaren Materialien bestehen und die in Fig. 4A und 4B gezeigten beispielhaften Konfigurationen aufweisen. Die Dichtungen 28, 30, 32 können separat oder, bei anderen Ausführungsformen, zusammenhängend vorgesehen sein.

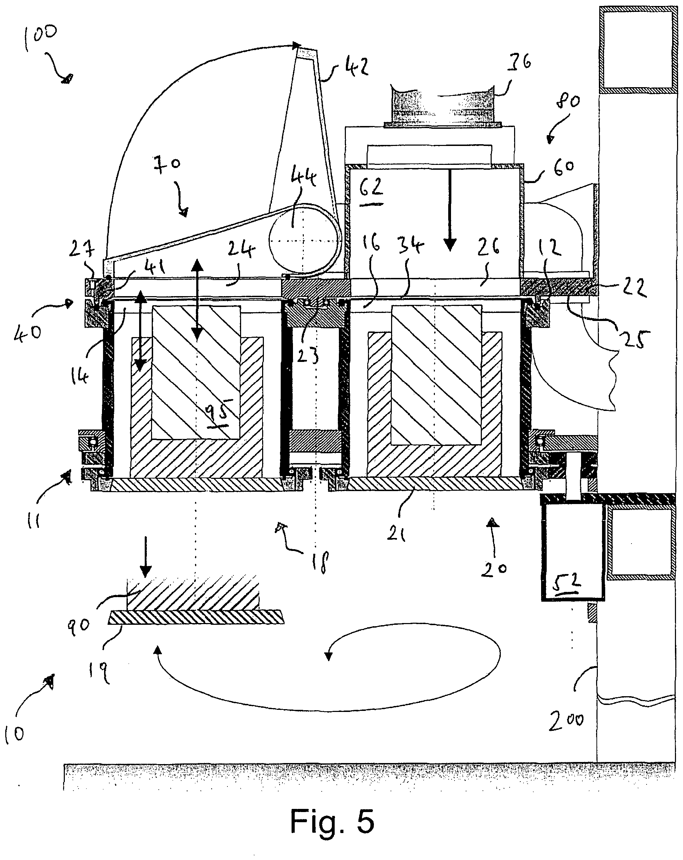

Einzelne Modifikationen der Teilchenstrahlbearbeitungsvorrichtung 100 werden im Folgenden unter Bezugnahme auf die Fig. 5-12 näher erläutert, wobei lediglich die Unterschiede zu der in den Fig. 1 und 2 gezeigten Ausführungsform erläutert werden.

Fig. 5 zeigt eine Teilchenstrahlbearbeitungsvorrichtung 100, die sich von der in Fig. 2 gezeigten Teilchenstrahlbearbeitungsvorrichtung darin unterscheidet, dass jede der Kammern 18, 20 einen abnehmbaren Drehboden 19 bzw. 21 aufweist, der auf der den Kammeröffnungen 24 bzw. 26 gegenüberliegenden Seite die Kammer verschließt. Die Drehböden können über ein Lager drehbar mit der jeweiligen Kammerwand verbunden sein und über einen geeigneten Drehantrieb wie dem Antrieb 52 um eine Drehachse parallel zu der Drehachse R des Rotors 10 gedreht werden, während das Werkstück 95 von dem Teilchenstrahlgenerator 36 bearbeitet wird. Ferner kann, wie in Fig. 5 gezeigt, der Werkstückwechsel an der Arbeitsstation 90 auch von unten vorgenommen werden, indem beispielsweise der Drehboden 19 abgenommen wird, wenn sich die Kammer 18 unterhalb der Arbeitsöffnung 24 befindet. Bei einigen Ausführungsformen kann der Deckel 42 auch weggelassen sein, so dass lediglich an einer geeigneten Position ein Anschluss zum Evakuieren der Kammer 18 vorgesehen sein kann.

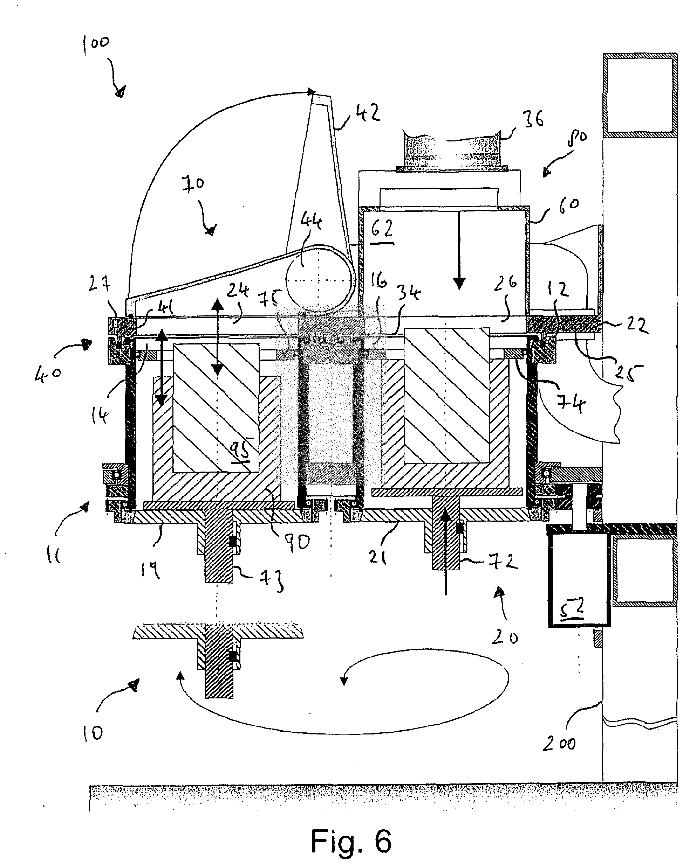

Bei der in Fig. 6 gezeigten Teilchenstrahlbearbeitungsvorrichtung ist eine Hubvorrichtung 73 bzw. 72 durch eine Öffnung in dem Boden 19 bzw. 21 der Kammern 18, 20 vakuumdicht hindurchgeführt. Dies ermöglicht ein Anheben der Werkstückaufnahme 90 bzw. des Werkstücks 95 vor bzw. während einer Bearbeitung. Somit können die Werkstückaufnahme 90 bzw. das Werkstück 95 während der Bearbeitung an einem Gegenlager 74, 75 gelagert und fixiert sein. Auch in diesem Fall kann der Werkstückwechsel von oben und/oder unten durchgeführt werden.

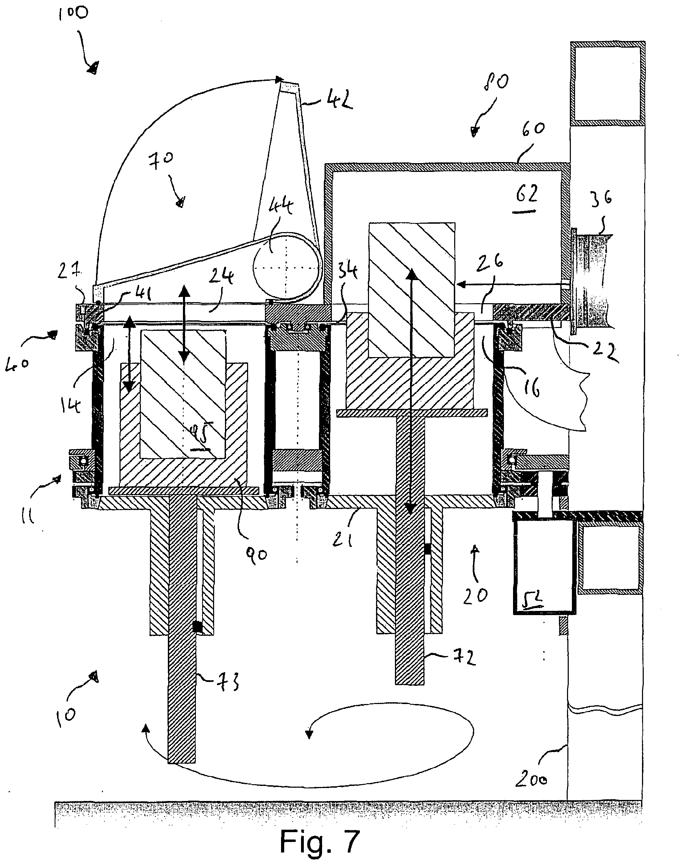

Fig. 7 zeigt ein Modul einer Bearbeitungsstation 80 mit einem horizontal angeordneten Teilchenstrahlgenerator 36. Wie in Fig. 7 gezeigt, ist der Teilchenstrahlgenerator 36 seitlich an dem Bearbeitungsgehäuse 60 befestigt und kann bei Bedarf über entsprechende Linear- oder Exzenterbewegungsvorrichtungen verfahren werden. Zur Bearbeitung eines Werkstücks in den Kammern 18, 20 sind Hubvorrichtungen 72, 73 vorgesehen, die im Vergleich zu der in Fig. 6 gezeigten Ausführungsform einen größeren Hub liefern können. Somit kann das zu bearbeitende Werkstück 95 an der Bearbeitungsstation 80 durch die Arbeitsöffnung 26 hindurch in den Bearbeitungsraum 62 hinein bewegt werden. Bei einer entsprechenden Drehung der Hubvorrichtung 72 kann das Werkstück dann von allen Seiten bearbeitet werden.

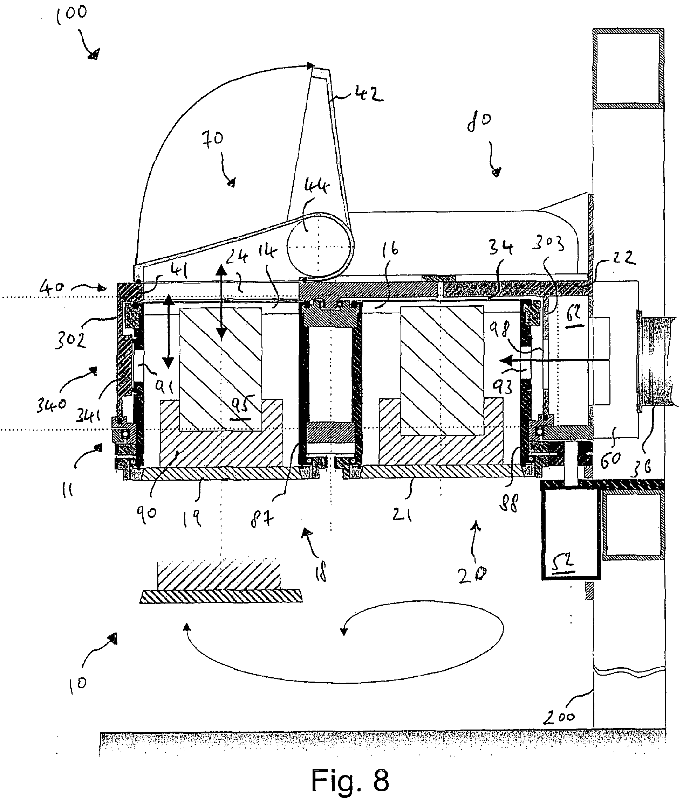

In Fig. 8 ist eine Modifikation der Teilchenstrahlbearbeitung 100 gezeigt, bei der die Bearbeitung an der Bearbeitungsstation 80 nicht von der Oberseite der Abdeckung 22 aus durchgeführt wird, sondern von der Seite. Dazu ist die Abdeckung 22 wie in Fig. 8 gezeigt so ausgebildet, dass sie eine Seitenwand mit Seitenwandabschnitten 302 und 303 aufweist, die mit der Oberseite der Abdeckung 22 eine verschließbare Kammer festlegt, in der der Rotor 10 aufgenommen ist bzw. die durch den Rotor verschlossen wird. Der Bauteilwechsel erfolgt wie bei den vorher beschriebenen Ausführungsformen an der Arbeitsstation 70. Dazu ist um die Arbeitsöffnung 24 der Wulst 41 vorgesehen, um auf die vorher beschriebene Weise die Dichtung der mit der Arbeitsöffnung 24 ausgerichteten Kammer in Eingriff zu nehmen.

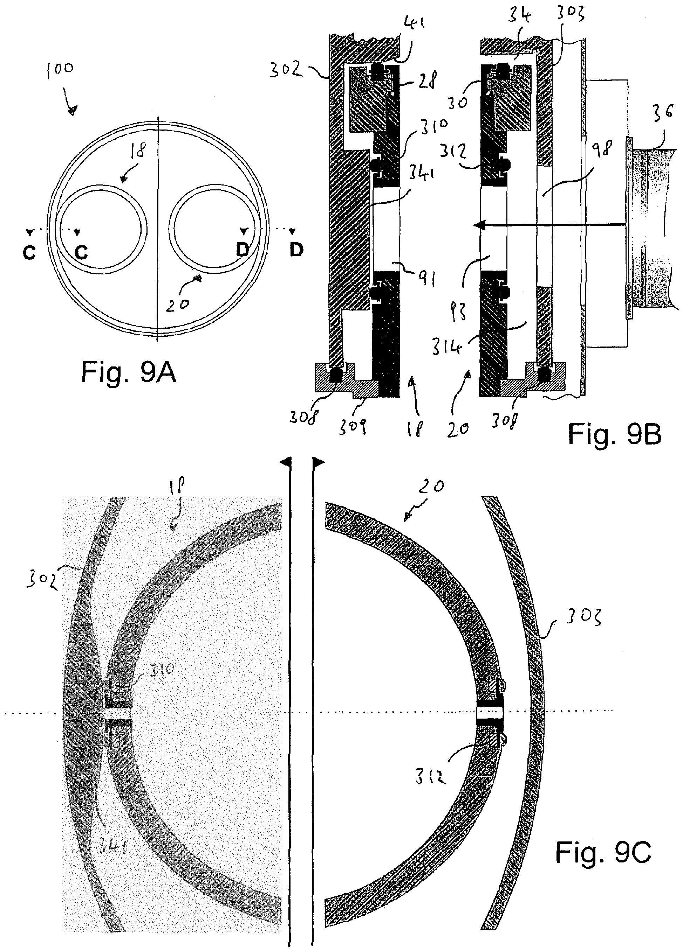

Damit die Bearbeitung des Werkstücks 95 in der Kammer 20 an der Bearbeitungsstation 80 erfolgen kann, ist in der Wand der Kammer 20 eine Arbeits- bzw. Wandöffnung 93 vorgesehen. Wenn sich die Kammer 20 an der Bearbeitungsstation 80 befindet, ist diese Wandöffnung 93 mit einer in dem gegenüberliegenden Seitenwandabschnitt 303 der Abdeckung 22 ausgebildeten Bearbeitungsöffnung 98 ausgerichtet, über der auf die vorher beschriebene Weise der Teilchenstrahlgenerator 36 angeordnet ist. Zwischen der Wand der Kammer 20 und dem Seitenwandabschnitt 303 ist ein Raum 314 ausgebildet (siehe Fig. 9B), der mit dem Raum 34 in Verbindung steht. Während einer Bearbeitung des Werkstücks in der Kammer 20 sind die Räume 34 und 314 sowie das Innere der Kammer 20 evakuiert. Damit während der Bearbeitung ein Werkstückwechsel an der Arbeitsstation 70 durchgeführt werden kann, ist an dem der Bearbeitungsöffnung 98 gegenüberliegenden Seitenwandabschnitt 302 der Abdeckung 22 eine weitere Abdichteinrichtung 40 erfindungsgemäß in Form eines Vorsprungs bzw. einer Verdickung 341 ausgebildet. Der Vorsprung 341 nimmt bei einer Drehung des Rotors 10, so dass die Kammer 18 mit der Arbeitsöffnung 24 ausgerichtet ist, die um die Wandöffnung 91 der Kammer 18 angeordnete Dichtung in Eingriff, so dass das Innere der Kammer 18 von dem Raum 34 und dem Raum 314 getrennt ist. Somit kann der Deckel 42 geöffnet werden, ohne dass das Vakuum an der Bearbeitungsstation 80 beeinträchtigt wird.

Die Fig. 9A-9C zeigen Details des Aufbaus der Teilchenstrahlbearbeitungsvorrichtung 100 in Fig. 8.

Fig. 9A zeigt schematisch eine Draufsicht auf die Teilchenstrahlbearbeitungsvorrichtung 100 gemäß dieser Ausführungsform. Fig. 9B zeigt zwei Schnittansichten entlang der Linien C-C und D-D in Fig. 9A. Fig. 9C zeigt schematisch eine Schnittansicht in der Ebene senkrecht zu der Drehachse des Rotors 10.

Wie in Fig. 9B gezeigt, ist die in der Kammerwand der Kammer 18 ausgebildete Wandöffnung 91 von einer Dichtung 310 umgeben. Ferner ist die in der Kammerwand der Kammer 20 ausgebildete Wandöffnung 93 von einer Dichtung 312 umgeben. Darüber hinaus ist an dem Rotor 10 ein umlaufender Vorsprung 309 ausgebildet, der mit Enden der Seitenwand der Abdeckung 22 über eine Dichtung 308 in Eingriff ist, so dass der Raum 314 begrenzt wird. Die Dichtung 308 kann ähnlich zu der Dichtung 32 aufgebaut sein, die im Vorhergehenden beschrieben wurde. Auf ähnliche Weise können die Dichtungen 310, 312 wie die vorher beschriebenen Dichtungen 28, 30 aufgebaut sein.

Wie in Fig. 9C schematisch gezeigt ist, ist die Abdichteinrichtung 340 als eine Verdickung bzw. ein Vorsprung 341 auf der Innenseite des Seitenwandabschnitts 302 ausgebildet. Die Geometrien der Verdickung 341 bzw. der Kammern 18, 20 sind derart aufeinander abgestimmt, dass die Dichtung, die die Wandöffnung der Kammer umgibt, die zu der Arbeitsstation 70 bewegt wird, mit der Verdickung in Eingriff kommt, wenn sich die Kammer an der Arbeitsstation 70 befindet. An allen anderen Positionen ist die Dichtung außer Eingriff mit der Innenseite der Seitenwand der Abdeckung 22, wie in Fig. 9C gezeigt ist. Dabei kann beispielsweise der Wandabschnitt um die Wandöffnung abgeflacht sein. Ferner kann die Verdickung bzw. der Vorsprung 341 die in Fig. 9C gezeigte konvexe oder eine ähnliche Form aufweisen.

Mit der in den Fig. 8 und 9 gezeigten Ausführungsform ist es möglich, auch von der Seite aus eine Bearbeitung eines Werkstücks in der einen Kammer 20 durchzuführen, während in der anderen Kammer 18 gleichzeitig ein Werkstückwechsel durchgeführt wird.

Für Fachleute ist offensichtlich, dass bei einer Modifikation der in den Fig. 8 und 9 gezeigten Ausführungsform der Werkstückwechsel auch von unten aus durchgeführt werden könnte. Dann könnte die Arbeitsöffnung 24 weggelassen werden, und die Abdeckung 22 könnte vollständig geschlossen sein. Somit könnte auch die Abdichteinrichtung 40 bzw. der Wulst 41 weggelassen werden.

Im Vorhergehenden wurde eine Ausführungsform der Teilchenstrahlbearbeitungsvorrichtung 100 beschrieben, die als eine Zweikammerteilchenstrahlbearbeitungsvorrichtung ausgebildet ist. Es versteht sich jedoch, dass bei anderen Ausführungsformen mehr als zwei Kammern 18, 20 vorgesehen sein können. Dies kann z.B. dann sinnvoll sein, wenn eine Bearbeitung relativ kurz dauert, so dass die für einen Werkstückwechsel und eine Evakuierung zur Verfügung stehende Zeit ebenfalls relativ kurz ist. In diesem Fall kann beispielsweise eine separate Evakuierungsstation vorgesehen sein. Ebenso ist es beispielsweise möglich, zwei oder mehr Paare aus einer Be-/Entladestation und einer Bearbeitungsstation vorzusehen, die jeweils in radialer Richtung gegenüberliegend oder alternierend angeordnet sind, so das gleichzeitig zwei oder mehr Bearbeitungsvorgänge und zwei oder mehr Be-/Entladevorgänge durchgeführt werden können.

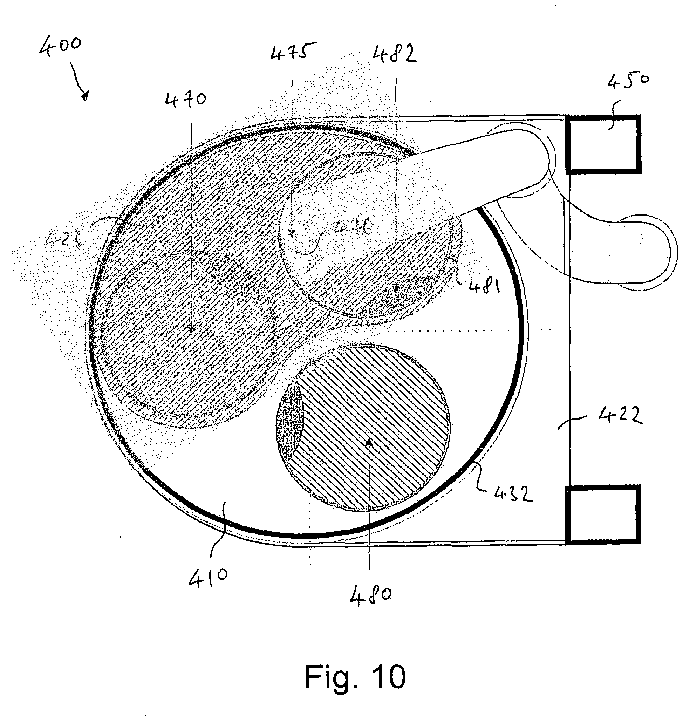

Ein Beispiel für eine Dreikammerteilchenstrahlbearbeitungsvorrichtung 400 ist in Fig. 10 gezeigt.

Wie in Fig. 10 gezeigt, weist die Dreikammerteilchenstrahlbearbeitungsvorrichtung 400 einen Rotor 410 mit drei Kammern auf, der von einer Abdeckung 422 abgedeckt wird. Die Abdeckung 422 kann erneut mittels einer Schwenkvorrichtung 450 schwenkbar über dem Rotor angeordnet sein oder auf andere Weise montiert sein. Ähnlich zu der beispielsweise in Fig. 2 gezeigten Teilchenstrahlbearbeitungsvorrichtung 100 sind eine Bearbeitungsstation 480 und eine Be-/Entladestation 470 vorgesehen. Zusätzlich dazu ist eine separate Evakuierungsstation 475 vorgesehen. Die Öffnungen der drei Kammern sind jeweils von einer Dichtung 481 umgeben, bei dem in Fig. 10 gezeigten Beispiel eine kreisförmige Dichtung mit einem Verdickungsabschnitt 482, auf den im Folgenden näher eingegangen wird. Ferner sind die Dichtungen der drei Kammern von einer äußeren Dichtung 432 umgeben, ähnlich wie in Fig. 3 für die Zweikammerteilchenstrahlbearbeitungsvorrichtung gezeigt ist.

Die Abdeckung 422 ist dazu angepasst, den Rotor der Teilchenstrahlbearbeitungsvorrichtung abzudecken und weist eine an der Evakuierungsstation 475 ausgebildete Evakuierungsöffnung 476 sowie einen an der Unterseite der Abdeckung 422 ausgebildeten Verdickungsbereich 423 auf, der in Richtung des Rotors vorsteht. Dies ist in Fig. 10 durch den schraffierten Bereich gekennzeichnet.

Bei der Teilchenstrahlbearbeitungsvorrichtung 400 ist erneut zwischen dem Rotor 410 und der Abdeckung 422 ein Spalt bzw. Raum ausgebildet, der nach außen von der Dichtung 432 begrenzt wird. Bei einer Drehung des Rotors 410 an die in Fig. 10 gezeigte Position befindet sich die Dichtung der Kammer, die unterhalb der Be-/Entladestation 470 positioniert ist, in Eingriff mit dem Verdickungsbereich 423 der Abdeckung 422. Auf ähnliche Weise befindet sich die Dichtung der Kammer, die unterhalb der Evakuierungsstation 475 angeordnet ist, in Eingriff mit dem Verdickungsbereich 423 der Abdeckung 422. Die Dichtung der Kammer, die unterhalb der Bearbeitungsstation 480 angeordnet ist, ist jedoch von der Abdeckung 422 beabstandet (ähnlich wie z.B. die in Fig. 3 gezeigte Dichtung 30). Auf diese Weise kann in der Kammer unterhalb der Bearbeitungsstation 480 sowie dem zwischen der Abdeckung 422 und dem Rotor 410 ausgebildeten Raum ein Vakuum vorliegen, während an der Be-/Entladestation 470 ein Bauteil gewechselt werden kann und an der Evakuierungsstation 475 die darunter angeordnete Kammer evakuiert werden kann. Die Evakuierung der Kammer an der Evakuierungsstation 475 erfolgt über die in der Abdeckung 422 ausgebildete Öffnung 476. Durch den Eingriff der entsprechenden Dichtung mit dem Verdickungsbereich 423 ist die zu evakuierende Kammer von den beiden anderen Kammern bzw. dem Raum zwischen der Abdeckung 422 und dem Rotor 410 getrennt. Nach der Evakuierung wird der Rotor 410 in Fig. 10 im Uhrzeigersinn gedreht, so dass die evakuierte Kammer mit dem neu eingesetzten Werkstück zu der Bearbeitungsstation 480 gebracht wird.

Die vorher erwähnte Verdickung 482 jeder der Dichtungen der Kammern dient dazu, beim Eintritt in die Evakuierungsstation 475 zu gewährleisten, dass das Vakuum, das zwischen der Abdeckung 422 und dem Rotor 410 vorliegt, nicht beeinträchtigt wird. Dazu ist der Verdickungsabschnitt 482 an die Größe der Öffnung 476 angepasst. Bei anderen Ausführungsformen kann der Verdickungsabschnitt 482 auch weggelassen werden.

Der Bauteilwechsel an der Be-/Entladestation 470 erfolgt von unten, auf ähnliche Weise wie z.B. in Fig. 5 gezeigt ist. Die Bearbeitung an der Bearbeitungsstation 480 kann mit einem vertikal oder horizontal angeordneten Generator erfolgen, wie er beispielsweise in den Fig. 5-7 gezeigt ist.

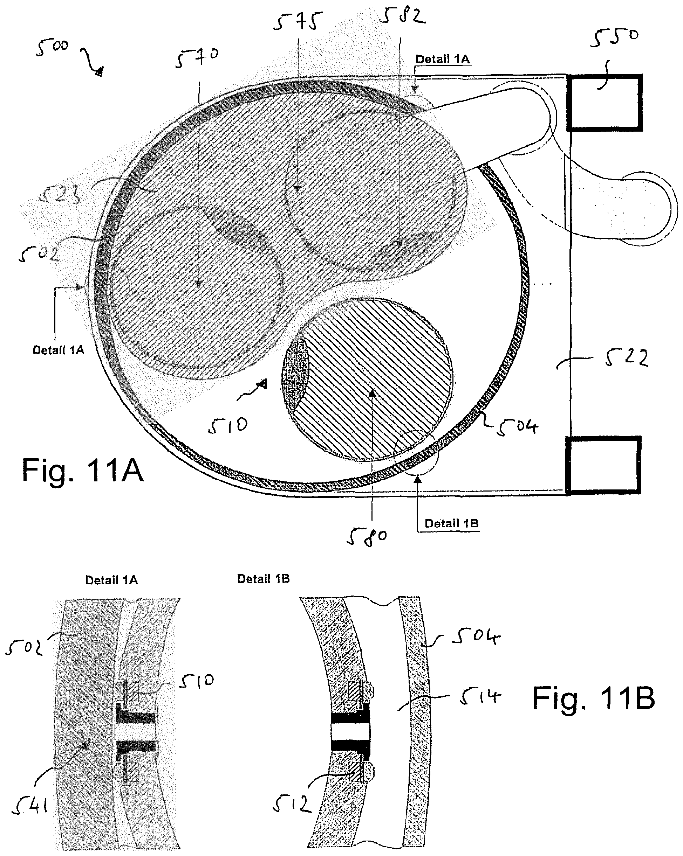

Ein weiteres Beispiel für eine Dreikammerteilchenstrahlbearbeitungsvorrichtung ist in den Fig. 11A und 11B gezeigt.

Wie in Fig. 11A gezeigt, weist die Dreikammerteilchenstrahlbearbeitungsvorrichtung 500 einen Rotor 510 mit drei Kammern auf, der von einer Abdeckung 522 abgedeckt wird. Die Abdeckung 522 kann erneut über eine Schwenkvorrichtung 550 oder dergleichen über dem Rotor montiert sein. Die Abdeckung 522 weist eine zu dem Rotor hin vorstehende Seitenwand mit Seitenwandabschnitten 502, 504 auf, die den Rotor vollständig umgibt.

Wie in Fig. 11A gezeigt, weist die Teilchenstrahlbearbeitungsvorrichtung 500 eine Bearbeitungsstation 580, eine Be-/Entladestation 570 und eine Evakuierungsstation 575 als drei Arbeitsstationen auf. Dabei ist die Teilchenstrahlbearbeitungsvorrichtung 500 derart aufgebaut, dass eine Bearbeitung eines Werkstücks an der Bearbeitungsstation 580 unter Vakuum durchgeführt werden kann, während zugleich ein Werkstückwechsel an der Be-/Entladestation 570 durchgeführt wird und an der Evakuierungsstation 575 die darunter angeordnete Kammer evakuiert wird.

Die Teilchenstrahlbearbeitungsvorrichtung 500 ist dabei im Wesentlichen ähnlich zu der in den Fig. 8 und 9 gezeigten Teilchenstrahlbearbeitungsvorrichtung aufgebaut. Das heißt, wie in Fig. 11B gezeigt, ist der Seitenwandabschnitt 502 derart ausgebildet, dass er in Bezug auf den gegenüberliegenden Seitenwandabschnitt 504, der bei der Bearbeitungsstation 580 vorgesehen ist, verdickt ist. Somit ist diejenige Dichtung 512, die die Wandöffnung der Kammer umgibt, die sich an der Bearbeitungsstation 580 befindet, nicht in Eingriff mit dem Seitenwandabschnitt 504, während die anderen Dichtungen, die die Wandöffnungen der beiden anderen Kammern umgeben, die an der Be-/Entladestation 570 und der Evakuierungsstation 575 angeordnet sind, mit dem gegenüberliegenden Seitenwandabschnitt 502 in Eingriff sind. Beispielsweise ist, wie in Fig. 11B gezeigt, die Dichtung 510, die ähnlich zu den Dichtungen 28, 30 ausgebildet sein kann, in Eingriff mit einem Verdickungsabschnitt 541 des Seitenwandabschnitts 502. Es ist offensichtlich, dass auf der Unterseite der Abdeckung 522 in dem Bereich der Be-/Entladestation 570 und der Evakuierungsstation 575 ebenfalls eine Verdickung bzw. geeignete Wulste vorgesehen sind, die dem in Fig. 8 gezeigten Wulst 41 entsprechen. Somit sind bei der in Fig. 11 gezeigten Ausführungsform die Kammern, die sich an der Be-/Entladestation 570 und der Evakuierungsstation 575 befinden, von der Kammer, die sich an der Bearbeitungsstation 580 befindet, sowie dem mit dem Inneren der Kammer an der Bearbeitungsstation 580 in Verbindung stehenden Raum und voneinander getrennt. Somit kann gleichzeitig eine Bearbeitung eines Werkstücks an der Bearbeitungsstation 580, ein Be-/Entladen an der Be-/Entladestation 570 und eine Evakuierung an der Evakuierungsstation 575 durchgeführt werden. Dies wird ermöglicht durch das Zusammenwirken der Verdickung 541 in einem Abschnitt der Seitenwand der Abdeckung 522 mit einer an der Unterseite der Abdeckung 522 ausgebildeten Verdickung 523, die in Fig. 11A als schraffierter Bereich dargestellt ist.

Ähnlich zu der in Fig. 10 gezeigten Ausführungsform weisen die um die Kammern angeordneten Dichtungen ebenfalls einen Verdickungsabschnitt auf, der an eine (in Fig. 11A nicht gezeigte) Öffnung der Abdeckung 522 an der Evakuierungsstation 575 angepasst ist. Der Werkstückwechsel an der Be-/Entladestation 570 erfolgt erneut von unten.

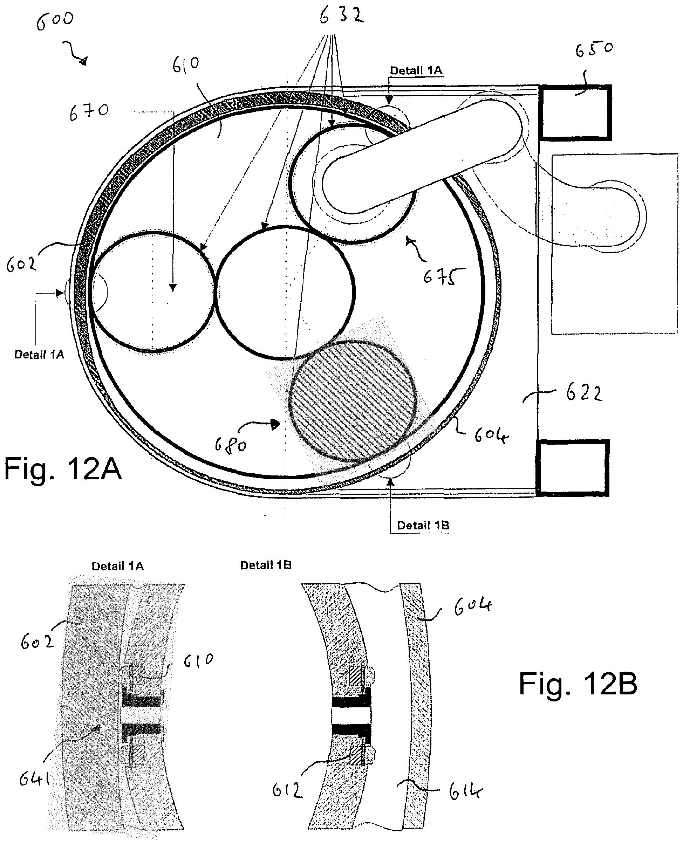

In den Fig. 12A und 12B ist ein weiteres Beispiel für eine Dreikammerteilchenstrahlbearbeitungsvorrichtung gezeigt.

Wie in Fig. 12A gezeigt, weist die weitere Teilchenstrahlbearbeitungsvorrichtung 600 einen Rotor 610 mit drei Kammern auf, der von einer Abdeckung 622 abgedeckt wird. Die der Abdeckung 622 gegenüberliegenden Öffnungen der Kammern sind von jeweiligen Dichtungen eines Dichtungssystems 632 umgeben. Das Dichtungssystem 632 enthält ferner einen inneren und einen äußeren Dichtring, zwischen denen die den einzelnen Kammern zugeordneten Dichtungen angeordnet sind. Diese Dichtringe können dabei zusammenhängend mit den Dichtungen der Kammern ausgebildet sein.

Bei der in Fig. 12 gezeigten Teilchenstrahlbearbeitungsvorrichtung 600 weist die Abdeckung 622 keine nach unten zu dem Rotor hin vorstehende Verdickung auf, so dass sich die Dichtungen des Dichtungssystems 632 stets in Eingriff mit der Abdeckung 622 befinden. Eine Be-/Entladestation 670 weist eine in der Abdeckung 622 ausgebildete Öffnung auf, durch die ein Bauteilwechsel erfolgen kann. Danach wird an einer Evakuierungsstation 675 eine Evakuierung durchgeführt, bevor an einer Bearbeitungsstation 680 eine Bearbeitung durch einen Teilchenstrahlgenerator erfolgt.

Bei der in Fig. 12 gezeigten Ausführungsform kann die Bearbeitung auf ähnliche Weise wie bei der in den Fig. 11A und 11B gezeigten Teilchenstrahlbearbeitungsvorrichtung erfolgen. Das heißt, die Bearbeitung kann von der Seite aus erfolgen, indem in einem Seitenwandabschnitt 604 der Seitenwand der Abdeckung 622, die dem Rotor 610 gegenüberliegt, so dass zwischen dem Rotor 610 und der Abdeckung 622 ein abgedichteter Raum 614 ausgebildet wird (siehe Fig. 12B), eine geeignete Öffnung vorgesehen ist. Durch eine entsprechende Wandöffnung in der im Bereich des Seitenwandabschnitts 604 angeordneten Kammer kann dann eine Bearbeitung eines Werkstücks in der Kammer auf die vorher beschriebene Weise erfolgen. Dabei sind die Wandöffnungen in den beiden anderen Kammern, wie vorher in Bezug auf die Ausführungsform in den Fig. 11A und 11B beschrieben, an einem Seitenwandabschnitt 602, der eine Abdichteinreichung 641 in Form eines verdickten Wandabschnitts aufweist, abgedichtet. Das heißt, der verdickte Außenwandabschnitt 602 ist derart vorgesehen, dass, wenn sich eine der Kammern an der Bearbeitungsstation 680 befindet, die Wandöffnungen in den anderen beiden Kammern in dem Bereich des Außenwandabschnitts 602 mit der Verdickung angeordnet sind, so dass sie über entsprechende Dichtungen (beispielsweise Dichtungen 610 und 612 in Fig. 12B) von dem Raum 614 zwischen der Abdeckung 622 und dem Rotor getrennt sind. Durch Zusammenwirken mit den einzelnen Dichtungen des Dichtungssystems 632 kann dann parallel ein Bauteilwechsel (von oben oder unten) an der Be-/Entladestation 670 und eine Evakuierung an der Evakuierungsstation 675 durchgeführt werden. Durch Drehung des Rotors im Uhrzeigersinn in Fig. 12A wird dann die Kammer, die gerade evakuiert wurde, zu der Bearbeitungsstation 680 bewegt, wobei die Dichtung 610 (siehe Fig. 12B) außer Kontakt mit der Seitenwandabdeckung 622 gebracht wird und die zugehörige Kammer mit dem Raum 614 verbunden wird.

Die oben beschriebenen Ausführungsformen sind so aufgebaut, dass der Rotor 10 sowie die Abdeckung 22 an einem gemeinsamen Rahmen 200 montiert sind. Ausführungsformen der vorliegenden Erfindungen sind jedoch nicht darauf beschränkt. So können beispielsweise der Rotor 10 und die Abdeckung 22 an separaten Rahmen oder anderen separaten Aufbauten montiert sein. Weitere Ausführungsformen und Modifikationen der offenbarten Teilchenstrahlbearbeitungsvorrichtungen werden sich für Fachleute anhand der Beschreibung sowie der beigefügten Zeichnungen ohne weiteres ergeben.

Beispielhafte Größen für die Teilchenstrahlbearbeitungsvorrichtung 100 können z.B. ein Rotordurchmesser zwischen etwa 300 mm und etwa 1500 mm sein, bevorzugt etwa 500 mm bis etwa 1000 mm, insbesondere etwa 400 mm bis etwa 900 mm. Entsprechende Kammerdurchmesser können zwischen etwa 50 mm und etwa 500 mm betragen, bevorzugt etwa 100 mm bis etwa 400 mm, insbesondere etwa 120 mm bis etwa 330 mm.

## Patentansprüche

1. Teilchenstrahlbearbeitungsvorrichtung (100) mit
einem Teilchenstrahlgenerator (36),
einem Rotor (10; 410; 510; 610), der um eine Drehachse (R) drehbar ist und eine Oberseite (12), eine erste Kammer (18) und eine zweite Kammer (20) aufweist, wobei die erste Kammer (18) eine erste Kammeröffnung (14; 91) aufweist, die von einer ersten Dichtung (28; 310; 510; 610) umgeben ist, und die zweite Kammer (20) eine zweite Kammeröffnung (16; 93) aufweist, die von einer zweiten Dichtung (30; 312; 512; 612) umgeben ist, einer Abdeckung (22; 422; 522; 622), die dem Rotor (10; 410; 510; 610) gegenüberliegt, und einer an der Abdeckung (22; 312; 512; 612) vorgesehenen Abdichteinrichtung (40; 340), die derart ausgebildet ist, dass durch eine Drehung des Rotors (10; 410; 510; 610) an eine Position, an der eine von der ersten Kammeröffnung (14; 91) und der zweiten Kammeröffnung (16; 93) mit der Abdichteinrichtung (40; 340) übereinstimmt, die zugehörige Dichtung (28, 30; 310, 312; 510, 512; 610, 612) aus einem Zustand, in dem sie außer Eingriff ist, in einen Zustand, in dem sie in dichtendem Eingriff mit der Abdichteinrichtung (40; 340) ist, bringbar ist,
**gekennzeichnet dadurch**, das
die Abdichteinrichtung (40; 340) als eine in Richtung des Rotors (10) vorstehende Verdickung (41; 341; 423; 541; 641) der Abdeckung (22; 422; 522; 622) ausgebildet ist.

2. Teilchenstrahlbearbeitungsvorrichtung nach Anspruch 1, bei der die erste Kammeröffnung (14) und die zweite Kammeröffnung (16) jeweils in der Oberseite (12) des Rotors (10; 410; 510) ausgebildet sind,
die Abdeckung (22; 422; 522) eine erste Arbeitsöffnung (24) und eine zweite Arbeitsöffnung (26) aufweist, mit denen jeweils die erste Kammeröffnung (14) und die zweite Kammeröffnung (16) in Übereinstimmung bringbar sind, und
die erste Arbeitsöffnung (24) von der Abdichteinrichtung (40) umgeben ist, so dass durch die Drehung des Rotors (10; 410; 510) an die Position, an der die eine von der ersten Kammeröffnung (14) und der zweiten Kammeröffnung (16) mit der Abdichteinrichtung (40) übereinstimmt, eine vakuumdichte Verbindung zwischen der einen von der ersten Kammeröffnung (14) und der zweiten Kammeröffnung (16) und der ersten Arbeitsöffnung (24) herstellbar ist.

3. Teilchenstrahlbearbeitungsvorrichtung nach Anspruch 2, ferner mit einer dritten Dichtung (32; 432), die die erste Dichtung (28) und die zweite Dichtung (30) umgibt und einen Raum (34) zwischen der Oberseite (12) des Rotors (10; 410) und der Abdeckung (22; 422) festlegt und dichtet, mit dem mindestens die erste Kammer (18) oder die zweite Kammer (20) in Verbindung steht, wobei bei Übereinstimmung einer der Kammern (18, 20) mit der ersten Arbeitsöffnung (24) die eine Kammer (18, 20) von dem Raum (34) getrennt ist, während die andere Kammer (18, 20) mit dem Raum (34) in Verbindung steht.

4. Teilchenstrahlbearbeitungsvorrichtung nach Anspruch 1, bei der die Verdickung als ein ringförmiger Wulst (41) ausgebildet ist, dessen Durchmesser an einen Durchmesser der ersten Dichtung (28) und der zweiten Dichtung (30) angepasst ist.

5. Teilchenstrahlbearbeitungsvorrichtung nach einem der Ansprüche 2 bis 3, bei der die erste Arbeitsöffnung (24) mit einer Evakuierungsvorrichtung (38) in Verbindung steht, die zum Evakuieren einer vakuumdicht mit der ersten Arbeitsöffnung (24) verbundenen Kammer (18, 20) ausgebildet ist, und der Teilchenstrahlgenerator (36) zur Bearbeitung eines in einer der Kammern (18, 20) angeordneten Werkstücks durch die zweite Arbeitsöffnung (26) angepasst ist.

6. Teilchenstrahlbearbeitungsvorrichtung nach Anspruch 5, bei der die erste Arbeitsöffnung (24) durch einen Deckel (42) verschließbar ist, der über einen Anschluss (44) mit der Evakuierungsvorrichtung (38) verbunden ist, so dass bei geschlossenem Deckel (42) die vakuumdicht mit der ersten Arbeitsöffnung (24) verbundene Kammer (18, 20) evakuiert werden kann, wobei der Deckel (42) zum Be- und Entladen der vakuumdicht mit der ersten Arbeitsöffnung (24) verbundenen Kammer (18, 20) geöffnet werden kann, während eine Bearbeitung des Werkstücks mit dem Teilchenstrahlgenerator (36) durch die zweite Arbeitsöffnung (26) durchgeführt wird.

7. Teilchenstrahlbearbeitungsvorrichtung nach einem der Ansprüche 1 bis 6, bei der die erste Dichtung (28; 310; 510; 610) und die zweite Dichtung (30; 312; 512; 612) zumindest teilweise aus einem Kunststoff wie PU 90 Sh bestehen und im Querschnitt ein Profil mit einer abgeschrägten Seitenfläche aufweisen.

## Claims

1. A particle beam processing device (100) comprising
a particle beam generator (36),
a rotor (10; 410; 510; 610) rotatable about a rotation axis (R) and including an upper surface (12), a first chamber (18) and a second chamber (20), the first chamber (18) including a first chamber opening (14; 91) surrounded by a first seal (28; 310; 510; 610), and the second chamber (20) including a second chamber opening (16; 93) surrounded by a second seal (30; 312; 512; 612),
a cover (22; 422; 522; 622) facing the rotor (10; 410; 510; 610), and
sealing means (40; 340) provided on the cover (22; 312; 512; 612) and being configured such that, by rotation of the rotor (10; 410; 510; 610) to a position where one of the first chamber opening (14; 91) and the second chamber opening (16; 93) aligns with the sealing means (40; 340), the corresponding seal (28, 30; 310, 312; 510, 512; 610, 612) can be brought from a state in which it is not engaged into a state in which it is in sealing engagement with the sealing means (40; 340),
**characterized in that**
the sealing means (40; 340) is configured as a thickening (41; 341; 423; 541; 641) of the cover (22; 422; 522; 622), which protrudes towards the rotor (10).

2. The particle beam processing device according to claim 1, wherein
the first chamber opening (14) and the second chamber opening (16) are formed in the upper surface (12) of the rotor (10; 410; 510), respectively,
the cover (22; 422; 522) includes a first work opening (24) and a second work opening (26), with each of which the first chamber opening (14) and the second chamber opening (16) can be brought into alignment, and
the first work opening (24) is surrounded by the sealing means (40) such that, by the rotation of the rotor (10; 410; 510) to the position where the one of the first chamber opening (14) and the second chamber opening (16) aligns with the sealing means (40), a vacuum-tight connection between the one of the first chamber opening (14) and the second chamber opening (16) and the first work opening (24) can be achieved.

3. The particle beam processing device according to claim 2, further comprising a third seal (32; 432) surrounding the first seal (28) and the second seal (30) and defining and sealing a space (34) between the upper surface (12) of the rotor (10; 410) and the cover (22; 422), said space being in communication with at least one of the first chamber (18) and the second chamber (20), wherein, upon alignment of one of the chambers (18, 20) with the first work opening (24), the one chamber (18, 20) is separated from the space (34), while the other chamber (18, 20) is communicated with the space (34).

4. The particle beam processing device according to claim 1, wherein the thickening is formed as an annular-shaped bulb (41), the diameter of which is adapted to a diameter of the first seal (28) and the second seal (30).

5. The particle beam processing device according to any one of claims 2 to 3, wherein the first work opening (24) is connected to an evacuation device (38) configured to evacuate a chamber (18, 20) that is connected to the first work opening (24) in a vacuum-tight manner, and the particle beam generator (36) is adapted to process a workpiece arranged in one of the chambers (18, 20) via the second work opening (26).

6. The particle beam processing device according to claim 5, wherein the first work opening (24) is closable by a lid (42) connected to the evacuation device (38) via a port (44) such that, when the lid (42) is closed, the chamber (18, 20) that is connected to the first work opening (24) in a vacuum-tight manner can be evacuated, wherein the lid (42) can be opened to load and unload the chamber (18, 20) that is connected to the first work opening (24) in a vacuum-tight manner, while a processing of the workpiece by the particle beam generator (36) via the second work opening (26) is performed.

7. The particle beam processing device according to any one of claims 1 to 6, wherein the first seal (28; 310; 510; 610) and the second seal (30; 312; 512; 612) are made at least in part of a plastic such as PU 90 Sh and have a profile including a tapered side surface in a cross-section.

## Revendications

1. Dispositif d'usinage par jets de particules (100) avec
un générateur de jets de particules (36),
un rotor (10 ; 410 ; 510 ; 610) qui peut être tourné autour d'un axe de rotation (R) et présente un côté supérieur (12), une première chambre (18) et une seconde chambre (20), dans lequel la première chambre (18) présente une première ouverture de chambre (14 ; 91) qui est entourée par un premier joint d'étanchéité (28 ; 310 ; 510 ; 610), et la seconde chambre (20) présente une seconde ouverture de chambre (16 ; 93) qui est entourée par un deuxième joint d'étanchéité (30 ; 312 ; 512 ; 612),
un recouvrement (22 ; 422 ; 522 ; 622) qui s'oppose au rotor (10 ; 410 ; 510 ; 610),
et un dispositif d'étanchéité (40 ; 340) prévu sur le recouvrement (22 ; 312 ; 512 ; 612) qui est réalisé de telle manière que par une rotation du rotor (10 ; 410 ; 510 ; 610) sur une position sur laquelle une de la première ouverture de chambre (14 ; 91) et de la seconde ouverture de chambre (16 ; 93) coïncide avec le dispositif d'étanchéité (40 ; 340), le joint d'étanchéité afférent (28, 30 ; 310, 312 ; 510, 512 ; 610, 612) peut être amené d'un état dans lequel il est hors prise, dans un état dans lequel il est en prise étanche avec le dispositif d'étanchéité (40 ; 340),
**caractérisé en ce que**
le dispositif d'étanchéité (40 ; 340) est réalisé en tant qu'épaississement (41 ; 341 ; 423 ; 541 ; 641) dépassant en direction du rotor (10) du recouvrement (22 ; 422 ; 522 ; 622).

2. Dispositif d'usinage par jets de particules selon la revendication 1, pour lequel
la première ouverture de chambre (14) et la seconde ouverture de chambre (16) sont réalisées respectivement dans le côté supérieur (12) du rotor (10 ; 410 ; 510),
le recouvrement (22 ; 422 ; 522) présente une première ouverture de travail (24) et une seconde ouverture de travail (26), avec lesquelles respectivement la première ouverture de chambre (14) et la seconde ouverture de chambre (16) peuvent être amenées à coïncider, et
la première ouverture de travail (24) est entourée du dispositif d'étanchéité (40) de sorte que par la rotation du rotor (10 ; 410 ; 510) sur la position, sur laquelle une de la première ouverture de chambre (14) et de la seconde ouverture de chambre (16) coïncide avec le dispositif d'étanchéité (40), une liaison étanche au vide entre l'une de la première ouverture de chambre (14) et de la seconde ouverture de chambre (16) et de la première ouverture de travail (24) puisse être établie.

3. Dispositif d'usinage par jets de particules selon la revendication 2, de plus avec
un troisième joint d'étanchéité (32 ; 432) qui entoure le premier joint d'étanchéité (28) et le deuxième joint d'étanchéité (30) et fixe et rend étanche un espace (34) entre le côté supérieur (12) du rotor (10 ; 410) et le recouvrement (22 ; 422), avec lequel au moins la première chambre (18) ou la seconde chambre (20) est en liaison, dans lequel lors de la coïncidence d'une des chambres (18, 20) avec la première ouverture de travail (24) l'une chambre (18, 20) est séparée de l'espace (34), alors que l'autre chambre (18, 20) est en liaison avec l'espace (34).

4. Dispositif d'usinage par jets de particules selon la revendication 1, pour lequel l'épaississement est réalisé en tant que bourrelet annulaire (41) dont le diamètre est adapté à un diamètre du premier joint d'étanchéité (28) et du deuxième joint d'étanchéité (30).

5. Dispositif d'usinage par jets de particules selon l'une quelconque des revendications 2 à 3, pour lequel la première ouverture de travail (24) est en liaison avec un dispositif d'évacuation (38) qui est réalisé pour l'évacuation d'une chambre (18, 20) raccordée de manière étanche au vide à la première ouverture de travail (24), et le générateur de jets de particules (36) est adapté pour l'usinage d'une pièce agencée dans une des chambres (18, 20) par la seconde ouverture de travail (26).

6. Dispositif d'usinage par jets de particules selon la revendication 5, pour lequel la première ouverture de travail (24) peut être refermée par un couvercle (42) qui est raccordé par le biais d'un raccordement (44) au dispositif d'évacuation (38) de sorte qu'en cas de couvercle fermé (42) la chambre (18, 20) raccordée de manière étanche au vide à la première ouverture de travail (24) puisse être évacuée, dans lequel le couvercle (42) peut être ouvert pour le chargement et le déchargement de la chambre (18, 20) raccordée de manière étanche au vide à la première ouverture de travail (24), alors qu'un usinage de la pièce avec le générateur de jets de particules (36) est réalisé par la seconde ouverture de travail (26).

7. Dispositif d'usinage par jets de particules selon l'une quelconque des revendications 1 à 6, pour lequel le premier joint d'étanchéité (28 ; 310 ; 510 ; 610) et le deuxième joint d'étanchéité (30 ; 312 ; 512 ; 612) se composent au moins partiellement d'une matière plastique telle que du PU 90 Sh et en section transversale présentent un profil avec une surface latérale chanfreinée.
